# FASCICULE DE BREVET EUROPEEN

(11) **EP 4 381 917 B1**
(45) Date de publication et mention de la délivrance du brevet: **04.06.2025**
(21) Numéro de dépôt: 22761999.6
(22) Date de dépôt: 04.08.2022
(51) Int. Cl.: H10N 50/20, G11C 11/16, G11C 11/22

(54) **DISPOSITIF ÉLECTRONIQUE ET SYSTÈME, NOTAMMENT UNE MÉMOIRE, DISPOSITIF LOGIQUE OU DISPOSITIF NEUROMORPHIQUE, ASSOCIÉ**
ELEKTRONISCHE VORRICHTUNG UND ZUGEHÖRIGES SYSTEM, INSBESONDERE EIN SPEICHER, LOGISCHE VORRICHTUNG ODER NEUROMORPHE VORRICHTUNG
ELECTRONIC DEVICE AND ASSOCIATED SYSTEM, IN PARTICULAR A MEMORY, LOGIC DEVICE OR NEUROMORPHIC DEVICE

(30) Priorité: 06.08.2021 FR 2108563
(43) Date de publication de la demande: 12.06.2024
(73) Titulaire: Commissariat à l'Energie Atomique et aux Energies Alternatives, 75015 Paris (FR); THALES, 92400 Courbevoie (FR); Centre National de la Recherche Scientifique, 75016 Paris (FR); Université Grenoble Alpes, 38400 Saint-Martin-d'Hères (FR)
(72) Inventeur: ATTANE, Jean-Philippe, 38054 GRENOBLE (FR); VILA, Laurent, 38054 GRENOBLE (FR); BIBES, Manuel, 91767 PALAISEAU (FR)
(74) Mandataire: Lavoix
(86) Numéro de dépôt international: PCT/EP2022/072003
(87) Numéro de publication internationale: WO 2023/012302

(56) Documents cités:
- WO-A1-2017/214628
- WO-A1-2020/136267
- CN-A- 111 755 447

## Description

La présente invention concerne un dispositif électronique, notamment dispositif mémoire, dispositif logique ou dispositif neuromorphique.

La présente invention se rapporte au domaine des dispositifs ferroélectriques aussi bien de type mémoires, logiques ou neuromorphique, en particulier pour les technologies de l'information et de la communication.

Les matériaux ferroélectriques portent une polarisation. Il est possible de coder une information dans cet état ferroélectrique, qui peut être écrite en appliquant une tension. Ceci a entraîné l'apparition de dispositifs ferroélectriques de type mémoires/logiques/neuromorphiques.

Un exemple de dispositif connu utilisant cet effet est la mémoire vive ferroélectrique Fe-RAM (renvoyant à la dénomination anglaise de « Ferroelectric Random Access Memory » qui signifie littéralement « Mémoire à accès aléatoire ferroélectrique »). La mémoire Fe-RAM est un dispositif de mémoire similaire à une mémoire vive dynamique DRAM (renvoyant à la dénomination anglaise de « Dynamic Random Access Memory » qui signifie littéralement « Mémoire à accès aléatoire dynamique ») à laquelle une couche ferroélectrique est ajoutée pour obtenir une propriété de non-volatilité. L'intérêt de la mémoire Fe-RAM est de combiner la rapidité de la mémoire vive et les caractéristiques non volatiles de la mémoire flash. Un autre exemple de dispositif connu est WO 2020/136267 A. Le document divulgue un dispositif qui comporte une unité d'application de courant de spin propre à appliquer un courant de spin à l'unité de conversion, une couche en un matériau ferroélectrique, dite couche ferroélectrique, présentant une polarisation ferroélectrique, la couche ferroélectrique étant agencée pour que la polarisation ferroélectrique contrôle au moins l'un parmi l'amplitude et le signe du courant de charge converti par l'unité de conversion.

Dans le cas d'une mémoire Fe-RAM, l'écriture d'une information à mémoriser est réalisée par application d'une tension entre les deux faces de la couche ferroélectrique. L'information est ainsi codée dans l'état de polarisation de la couche ferroélectrique.

La lecture est réalisée en appliquant une tension et en mesurant le courant produit. Plus précisément, une impulsion de tension est appliquée entre les deux faces de la couche ferroélectrique de manière à tenter de commuter la polarisation depuis un premier état à vers un deuxième état, par exemple depuis l'état « 0 » vers l'état « 1 ». Si la mémoire Fe-RAM était déjà dans l'état « 1 », le seul courant produit lu est lié à l'impulsion de tension appliquée. Si la mémoire Fe-RAM était initialement dans l'état « 0 », le courant produit sera la somme du courant lié à l'impulsion de tension et du courant de dépolarisation, lié au renversement de la polarisation.

Le mécanisme de lecture est ainsi destructif : la lecture efface l'état mémoire stocké, ce qui implique de réécrire la mémoire Fe-RAM au moyen d'une architecture particulière.

Il existe donc un besoin pour un moyen permettant de lire l'état de polarisation d'une couche ferroélectrique par un mécanisme non destructif notamment pour des applications mémoire.

A cet effet, la description décrit un dispositif électronique comprenant un empilement de couches empilées selon une direction d'empilement, l'empilement de couches comprenant une première électrode, comprenant au moins un contact électrique, un sous-ensemble ferroélectrique, le sous-ensemble ferroélectrique étant en contact avec la première électrode et présentant une polarisation ferroélectrique pouvant prendre plusieurs états. L'empilement de couches comprend également un sous-ensemble de polarisation en spin, le sous-ensemble de polarisation en spin étant propre à polariser en spin un courant passant au travers du sous-ensemble de polarisation en spin, au moins une couche du sous-ensemble de polarisation en spin étant en matériau ferromagnétique ou ferrimagnétique et un sous-ensemble d'interfaçage disposé entre le sous-ensemble ferroélectrique et le sous-ensemble de polarisation en spin, le sous-ensemble d'interfaçage étant propre à assurer l'interconversion du courant polarisé en spin en courant de charge, en fonction de l'état de polarisation ferroélectrique du sous-ensemble ferroélectrique. Le sous-ensemble ferroélectrique et le sous-ensemble d'interfaçage présentent respectivement une partie superposée selon la direction d'empilement avec le sous-ensemble de polarisation en spin et une partie non superposée avec le sous-ensemble de polarisation en spin, au moins un sous-ensemble parmi le sous-ensemble d'interfaçage et le sous-ensemble ferroélectrique comportant une couche conductrice apte à former une électrode intermédiaire, cette électrode intermédiaire comprenant un contact électrique de lecture de l'état de polarisation du sous-ensemble ferroélectrique. L'empilement de couches comprend également une deuxième électrode comprenant au moins deux contacts électriques de lecture de l'état de la polarisation du sous-ensemble ferroélectrique, les contacts s'étendant chacun selon une direction principale respective, au moins deux directions principales étant non parallèles entre elles, la deuxième électrode délimitant le sous-ensemble de polarisation en spin, le contact de la première électrode permettant de modifier l'état de polarisation ferroélectrique du sous-ensemble ferroélectrique par application d'une différence de potentiel entre ce contact et au moins l'un des contacts de la deuxième électrode ou d'une différence de potentiel entre ce contact et le contact de l'électrode intermédiaire.

Selon des modes de réalisation particuliers, le dispositif électronique présente une ou plusieurs des caractéristiques suivantes, prise(s) isolément ou selon toutes les combinaisons techniquement possibles :
- le sous-ensemble d'interfaçage comprend au moins une couche en métal ou une barrière tunnel ou une couche à effet spin orbite, lorsque le sous-ensemble ferroélectrique est tout ou partie conducteur ou semiconducteur, ou une couche en métal ou une barrière tunnel ou une couche à effet spin-orbite ou un gaz bidimensionnel d'électrons lorsque le sous-ensemble ferroélectrique est isolant.
- le sous-ensemble ferroélectrique comprenant au moins une couche ferroélectrique semi-conductrice ou une couche ferroélectrique en matériau bidimensionnel conductrice ou semi-conductrice, ledit sous-ensemble d'interfaçage étant confondu avec le sous-ensemble ferroélectrique et comportant ladite au moins couche
- la deuxième électrode est une couche positionnée sur le sous-ensemble de polarisation en spin.
- la deuxième électrode et le sous-ensemble de polarisation en spin sont confondus.
- la deuxième électrode comporte au moins trois contacts.
- deux contacts de la deuxième électrode s'étendent selon des directions principales parallèles, le troisième contact de la deuxième électrode s'étendant selon une direction principale sensiblement perpendiculaire à la direction principale des deux autres contacts de la deuxième électrode.
- les directions principales de chaque contact de l'électrode intermédiaire et de la deuxième électrode sont toutes perpendiculaires à la direction d'empilement.
- le contact de la première électrode est soit dans une direction perpendiculaire à la direction d'empilement soit dans une direction sensiblement parallèle à la direction d'empilement.
- le sous-ensemble d'interfaçage comporte au moins un élément parmi un métal, un semi-métal de Weyl, un matériau bidimensionnel, un dichalcogénure de métaux de transition et un isolant topologique.
- le sous-ensemble d'interfaçage comprend une barrière en un matériau isolant, notamment un oxyde.
- le sous-ensemble de polarisation en spin comporte un alliage métallique ferromagnétique ou ferrimagnétique, un oxyde ferromagnétique ou ferrimagnétique, un semiconducteur magnétique, un élément ferromagnétique ou ferrimagnétique composite à plusieurs couches ferromagnétiques ou ferrimagnétiques et métalliques, un alliage d'Heusler ou un alliage ferromagnétique ou ferrimagnétique à base de terres rares.
- le sous-empilement ferroélectrique comprend un matériau ferroélectrique choisi parmi un matériau de structure pérovskite de type ABO₃ avec A et B des cations, du (Hf₁₋ₓZrₓ)O₂, du (Hf₁₋ₓGaₓ)O₂ où x est compris entre 0 et 1, ou du HfO₂ dopé avec d'autres éléments tels que le Zr ou le Ga, ou leurs alliages, du poly(fluorure de vinylidène), un semiconducteur ferroélectrique, et un matériau ferroélectrique bidimensionnel.
- les contacts réalisent la lecture de l'état de polarisation du sous-ensemble de polarisation en spin par application d'une tension de lecture entre deux contacts dits de lecture choisis parmi le contact de l'électrode intermédiaire et les contacts de la deuxième électrode et en mesurant la tension entre deux des autres contacts dits de lecture ou entre un desdits autres contacts dits de lecture et un potentiel de référence..

La description décrit aussi un système, notamment mémoire, dispositif logique ou dispositif neuromorphique, comportant un dispositif électronique..

Des caractéristiques et avantages de l'invention apparaîtront mieux à la lecture de la description qui va suivre, donnée uniquement à titre d'exemple indicatif et non limitatif, et faite en référence aux dessins annexés, sur lesquels :
- la figure 1 est une représentation schématique d'un exemple de dispositif électronique,
- la figure 2 est une représentation schématique d'un autre exemple dispositif électronique,
- la figure 3 est une représentation schématique d'un autre exemple de dispositif électronique, et
- la figure 4 est une représentation schématique d'un autre exemple de dispositif électronique.

Pour simplifier la description, on choisira comme exemple d'application du dispositif électronique de l'invention une mémoire, sachant que ces dispositifs peuvent également permettre la réalisation de dispositifs logiques ou neuromorphiques.

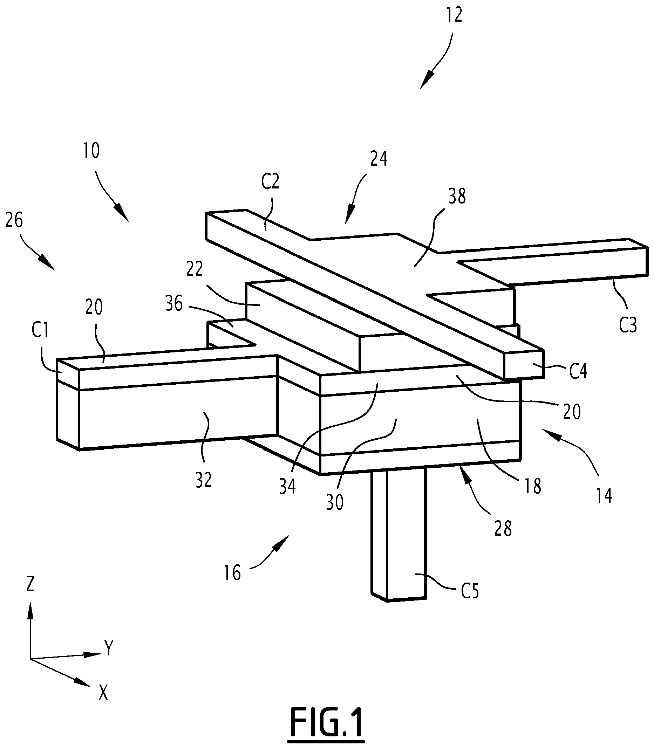

Ainsi, sur la figure 1, on a représenté un dispositif électronique 12 d'une mémoire 10. Cette mémoire 10 comporte, en outre, une unité de lecture et une unité d'écriture, les unités de lecture et d'écriture n'étant pas représentées dans un souci de lisibilité de la figure 1.

Le dispositif électronique 12 comporte un empilement de couches 14.

Les couches de l'empilement 14 sont des couches empilées selon une direction d'empilement Z.

Il est alors défini deux directions longitudinales qui sont perpendiculaires à la direction d'empilement Z, une première direction longitudinale X et une deuxième direction longitudinale Y. Les deux directions longitudinales X et Y sont orthogonales entre elles et choisies de sorte que le repère X, Y et Z soit direct. Les deux directions X, Y définissent un plan parallèle au plan des couches de l'empilement

En référence à la figure 1, il est également défini des notions relatives de bas et de haut par rapport à la direction d'empilement Z. Une couche est située plus bas qu'une autre couche (au-dessous) si elle est plus basse dans la représentation sur la feuille de la figure 1, étant bien entendu que l'empilement peut avoir le sens inverse dans la direction Z.

Enfin, l'épaisseur d'une couche est définie comme la dimension le long de la direction d'empilement Z de la couche, c'est-à-dire la distance entre ses deux faces.

Dans l'exemple de la figure 1, l'empilement de couches 14 comprend depuis le bas vers le haut une première électrode 16, un sous-ensemble ferroélectrique 18, un sous-ensemble d'interfaçage 20, un sous-ensemble de polarisation en spin 22 et une deuxième électrode 24.

Dans la suite, par commodité, la première électrode 16 est dite électrode inférieure et la deuxième électrode 24 est dite électrode supérieure.

Le dispositif électronique 10 comporte, en outre, une électrode intermédiaire 26, l'électrode intermédiaire 26 comprenant un contact, noté contact C1 sur la figure 1.

Dans l'exemple décrit, l'électrode inférieure 16 comporte un contact, noté contact C5 sur la figure 1, et l'électrode supérieure 24 comporte dans cet exemple trois contacts (mais au moins deux contacts suffisent), de sorte que le dispositif électronique 10 comporte au moins quatre contacts.

Aussi, dans la suite, le contact de l'électrode intermédiaire 26 est dénommé premier contact C1, les contacts de l'électrode supérieure 24 sont dénommés respectivement deuxième contact C2, troisième contact C3, quatrième contact C4 et le contact de l'électrode inférieure 16 est dénommé cinquième contact C5.

Chaque contact C1, C2, C3, C4 et C5 est un contact électrique.

Dans la représentation de la figure 1, chaque contact C1, C2, C3, C4 et C5 est représenté sous la forme d'un parallélépipède s'étendant selon une direction principale.

Bien que cette forme soit non limitative, chaque contact C1, C2, C3 et C4 présente une direction principale respective.

Selon l'exemple de la figure 1, l'électrode inférieure 16 comporte le cinquième contact C5 et une couche de contact 28.

En variante, l'électrode inférieure 16 peut comporter plusieurs contacts.

Dans l'exemple décrit, le cinquième contact C5 s'étend principalement selon la direction d'empilement Z.

En variante, le cinquième contact C5 s'étend dans une direction sensiblement parallèle à la direction d'empilement Z.

Par l'expression « sensiblement » dans ce contexte, il est entendu une égalité à 15° près.

Il apparaîtra dans la suite de la description que le cinquième contact C5 permettant de modifier l'état de polarisation ferroélectrique du sous-ensemble ferroélectrique 18 par application d'une différence de potentiel entre ce contact C5 et au moins l'un des contacts C2, C3 ou C4 de la deuxième électrode 24.

Alternativement, le cinquième contact C5 permettant de modifier l'état de polarisation ferroélectrique du sous-ensemble ferroélectrique 18 par application d'une différence de potentiel entre ce contact C5 et le premier contact C1 de l'électrode intermédiaire 26.

L'épaisseur de la couche de contact 28 est typiquement comprise entre 0,2 nanomètre (nm) et 100 nm.

Selon l'exemple décrit, l'électrode inférieure 16 est réalisée en un matériau métallique.

En variante, l'électrode inférieure 16 est en un matériau semi-conducteur dopé.

Pour chaque électrode 16 ou 24, le contact des électrodes peut être réalisé dans la même couche que l'électrode ou réalisée indépendamment de la couche formant l'électrode et peut être ou non dans le même matériau que celle-ci.

Le sous-ensemble ferroélectrique 18 présente une polarisation ferroélectrique apparente pouvant prendre plusieurs états, c'est-à-dire qu'elle présente une relation non-linéaire entre la tension V appliquée entre ses faces et la charge Q stockée apparente suivant un cycle d'hystérésis, résultant en au minimum deux états rémanents.

Dans l'exemple de la figure 1, le sous-ensemble ferroélectrique 18 est en contact avec l'électrode inférieure 16.

Le sous-ensemble ferroélectrique 18 est composée d'une mono ou d'une multicouche comportant un ou des matériaux assurant des propriétés ferroélectriques à l'empilement résultant.

Plusieurs exemples de matériau ferroélectrique pouvant être utilisés pour réaliser au moins une couche de ce sous-ensemble ferroélectrique 18 sont maintenant décrits.

Selon un premier exemple, le matériau ferroélectrique est un oxyde présentant une structure pérovskite de type ABO₃ (où A et B sont des cations).

Ainsi, le matériau ferroélectrique présent dans le sous-ensemble ferroélectrique 18 est, par exemple, en BaTiO₃, en PZT (c'est-à-dire en PbZr₁₋ₓTiₓO₃ avec x variant entre 0 et 1), en PMN-PT (c'est-à-dire en [1-x]Pb(Mg_{1/3}Nb_{2/3})O₃ - xPbTiO₃ avec x variant entre 0 et 1), en BiFeO₃ (éventuellement dopé, par exemple en terres rares sur le site du Bi, ou en Mn sur le site du Fe), en SrTiO₃ (éventuellement dopé), en KTiO₃ (éventuellement dopé), en Pr_{0,7}Ca_{0,3}MnO₃ (éventuellement dopé) ou en YMnO₃ (éventuellement dopé).

Selon un deuxième exemple, le matériau ferroélectrique est du (Hf₁₋ₓZrₓ)O₂ ou du (Hf₁₋ₓGaₓ)O₂ (x variant entre 0 et 1), ou du HfO₂ dopé avec d'autres éléments, ou leurs alliages.

Le matériau ferroélectrique peut également être du poly(fluorure de vinylidène).

Dans un tel deuxième exemple, le matériau ferroélectrique n'a pas la structure pérovskite au contraire du premier exemple.

Selon un troisième exemple, le matériau ferroélectrique est un semiconducteur ferroélectrique. Le GeTe, éventuellement dopé ou l'AIScN, sont des exemples de matériaux semiconducteurs ferroélectriques.

Selon un quatrième exemple, le matériau ferroélectrique est un matériau ferroélectrique bidimensionnel. SnTe ou CuInP₂S₆ sont des exemples de matériaux ferroélectriques bidimensionnels.

Dans chacun des exemples précités, le matériau ferroélectrique peut être irradié, recuit, dopé ou déposé sur des substrats spécifiques de manière à moduler ses propriétés ferroélectriques et de transport.

Selon l'exemple décrit, le champ électrique coercitif de l'élément ferroélectrique et son épaisseur sont suffisamment faibles pour que la polarisation puisse être renversée à des tensions compatibles avec les technologies microélectroniques, c'est-à-dire des tensions inférieures à 10 Volts (<10 V). Une épaisseur inférieure à 150 nm et avantageusement inférieure à 50 nm dans les matériaux précités permet d'obtenir de telles propriétés. Le sous-ensemble ferroélectrique 18 est également endurant au cyclage, typiquement capable de supporter au moins 10⁴ cycles.

Le sous-ensemble de polarisation en spin 22 comporte au moins une couche magnétique réalisée en un matériau ferromagnétique ou ferrimagnétique.

Selon un premier cas, le matériau magnétique est un alliage métallique ferromagnétique ou ferrimagnétique composé par des éléments tels que Co, Fe, B, Ni ou Al.

Selon un deuxième cas, le matériau magnétique est un oxyde ferromagnétique ou ferrimagnétique.

Selon un troisième cas, le matériau magnétique est un semiconducteur magnétique.

Selon un quatrième cas, le matériau magnétique est un élément ferromagnétique ou ferrimagnétique composite de type [FM/M]ₙ/FM, c'est-à-dire un empilement de plusieurs couches ferromagnétiques ou ferrimagnétiques FM et métalliques M couplées entre elles.

Le nombre n varie avantageusement entre 1 et 50.

Les matériaux ferromagnétiques ou ferrimagnétiques FM sont, par exemple, ceux des trois premiers cas.

Les matériaux métalliques M sont, par exemple, choisis parmi AI, Ta, Ru, Pt, W, Ir, Mo, Ti, Y et Au.

Selon un cinquième cas, le matériau magnétique est un alliage d'Heusler.

A titre d'exemple, l'alliage d'Heusler est choisi parmi le Cu₂MnAl, le Cu₂MnIn, le Cu₂MnSn, le NfiMnAl, le NfiMnln, le NfiMnSn, le NfiMnSb, le Ni₂MnGa, le Co₂MnAl, le Co₂MnSi, le Co₂MnGa, le Co₂MnGe, le Pd₂MnAl, le Pd₂MnIn, le Pd₂MnSn, le Pd₂MnSb, le Co₂FeSi, le Co₂FeAl, le Fe₂VAl, le Mn₂VGa, le Co₂FeGe, le MnGa et le MnGaRu.

Selon un sixième cas, le matériau magnétique est un alliage à base de terres rares.

Par exemple, le matériau magnétique est un alliage à base de Nd, de Sm, d'Eu, de Gd, de Tb, ou de Dy.

Le sous-ensemble de polarisation en spin 22 sert à polariser en spin le courant de charge passant au travers du sous-ensemble de polarisation en spin 22.

Les spins au sein de ce sous-ensemble de polarisation en spin 22 sont avantageusement polarisés selon la première direction longitudinale X.

Dans le cas d'une aimantation rémanente relativement importante, une telle direction de polarisation des spins peut être obtenue par application d'un champ magnétique dans la première direction longitudinale X, afin de saturer l'aimantation.

Pour des matériaux magnétiquement plus doux, il est possible de créer une anisotropie dans le plan, par exemple en utilisant des techniques de recuit sous champ, en jouant sur l'anisotropie de forme, en texturant la surface de la couche magnétique, ou en utilisant un couplage d'échange avec une couche antiferromagnétique faisant partie du sous-ensemble de polarisation en spin 22.

En outre, l'épaisseur de la couche ferromagnétique est faible (typiquement inférieure à 100 nm), de manière à optimiser le signal lu par l'unité de lecture.

Le sous-ensemble de polarisation en spin 22 permet d'obtenir une polarisation en spin relativement assez élevée, de préférence supérieure à 0,1.

Le sous-ensemble ferroélectrique 18 et le sous-ensemble de polarisation en spin 22 sont agencés géométriquement de manière particulière.

En l'occurrence, le sous-ensemble ferroélectrique 18 présente deux parties 30 et 32.

La première partie 30 est une partie superposée 30 selon la direction d'empilement Z avec le sous-ensemble de polarisation en spin 22.

En l'espèce, la première partie 30 est une portion parallélépipédique.

La deuxième partie 32 est une partie non superposée 32 avec le sous-ensemble de polarisation en spin 22.

En l'espèce, la deuxième partie 32 est une portion présentant une forme de T, la barre horizontale du T étant en contact avec la première partie 30 et la barre verticale du T étant selon la deuxième direction longitudinale Y.

Le sous-ensemble d'interfaçage 20 délimite le sous-ensemble ferroélectrique 18.

Le sous-ensemble d'interfaçage 20 est disposé entre le sous-ensemble de polarisation en spin 22 et le sous-ensemble ferroélectrique 18. Dans le cas où le sous-ensemble ferroélectrique 18 comporte un matériau ferroélectrique semiconducteur ou un matériau ferroélectrique bidimensionnel, ledit sous-ensemble d'interfaçage 20 peut être confondu avec le sous-ensemble ferroélectrique 18.

Selon l'exemple de la figure 1, le sous-ensemble d'interfaçage 20 présente deux parties 34 et 36.

La première partie 34 du sous-ensemble d'interfaçage 20 correspond à la partie superposée 30 du sous-ensemble ferroélectrique 18.

Dans le cas illustré, la première partie 34 est superposée avec la partie superposée 30 du sous-ensemble ferroélectrique 18.

La deuxième partie 36 du sous-ensemble d'interfaçage 20 correspond à la partie non superposée 32 du sous-ensemble ferroélectrique 18.

En l'espèce, la première partie 34 est superposée avec la barre horizontale du T de la partie non superposée 32 du sous-ensemble ferroélectrique 18.

Dans la figure 1, la première partie 34 du sous-ensemble d'interfaçage 20 est ainsi superposée avec le sous-ensemble de polarisation en spin 22 le long de la direction d'empilement Z, alors que la deuxième partie 36 du sous-ensemble d'interfaçage 20 n'est pas superposée avec le sous-ensemble de polarisation en spin 22.

Autrement formulé, au moins l'un parmi le sous-ensemble d'interfaçage 20 et le sous-ensemble ferroélectrique 18 comporte une couche conductrice apte à former l'électrode intermédiaire 26, électrode qui comprend le premier contact C1 qui est un contact électrique de lecture de l'état de polarisation du sous-ensemble ferroélectrique 18.

Selon un premier exemple, le sous-ensemble d'interfaçage 20 est constitué par ou comporte un gaz bidimensionnel d'électrons.

Selon un deuxième exemple, le sous-ensemble d'interfaçage 20 comporte une ou plusieurs couches d'interface servant à réaliser une conversion du courant de spin en courant de charge.

Il est à noter que la conversion de courant de spin en courant de charge dans le sous-ensemble d'interfaçage 20 est modulable par la ferroélectricité du sous-ensemble ferroélectrique 18, et suffisamment forte pour minimiser la consommation énergétique de la mémoire.

Notamment, le sous-ensemble d'interfaçage 20 comporte au moins une couche à fort effet spin-orbite, dite couche spin-orbite.

La couche spin-orbite présente une épaisseur relativement faible, typiquement inférieure ou égale à 10 nm.

Le matériau utilisé pour réaliser pour la couche spin-orbite varie selon les cas.

Selon un premier exemple, le matériau de la couche spin-orbite est un matériau à effet Hall de spin.

Un matériau un matériau à effet Hall de spin est un matériau permettant de convertir un courant de charge en courant de spin, possédant une angle d'effet Hall de spin typiquement supérieur à 5%

Par exemple, le matériau à effet Hall de spin spin-orbite peut être du Tantale sous sa phase β (β-Ta), du BiSb, du β-Tungstène (β -W), du W ou du Pt.

Selon un autre exemple, le matériau de la couche spin-orbite est du Cu ou de l'Au dopé avec des éléments des colonnes 3d, 4d, 5d, 4f, 5f de la classification périodique, comme W, Ta, Bi, de manière à obtenir des effets spin-orbite importants, ou une combinaison d'éléments 5d, tel que PtW.

Selon un deuxième cas, le matériau de la couche spin-orbite est un matériau spin-orbite bidimensionnel.

A titre d'exemple de ce deuxième cas, il peut être cité les matériaux suivants : le graphène, le BiSe₂, le BᵢS₂, BiSeₓTe₂₋ₓ (x variant entre 0 et 2), le BiS, le TiS, le WS₂, le MoS₂, le TiSe₂, le VSe₂, le MoSe₂, le B₂S₃, le Sb₂S, le T_{0,75}S, le Re₂S₇, le LaCPS₂, le LaOAsS₂, le ScOBiS₂, le GaOBiS₂, le AlOBiS₂, le LaOSbS₂, le BiOBiS₂, le YOBiS₂, le InOBiS₂, le LaOBiSe₂, le TiOBiS₂, le CeOBiS₂, le PrOBiS₂, le NdOBiS₂, le LaOBiS₂, ou le SrFBiS₂.

Les matériaux précités peuvent éventuellement être dopés.

Selon un troisième cas, le matériau de la couche spin-orbite est un isolant topologique. Un isolant topologique est un matériau ayant une structure de bande de type isolant mais qui possède des états de surface métalliques.

Par exemple, le matériau de la couche spin-orbite est du Bi₂Se₃, du BiSbTe, du SbTe₃, du HgTe ou du α-Sn.

Selon un quatrième cas, le matériau de la couche spin-orbite est un semimétal de Weyl.

Dans un tel cas, le matériau de la couche spin-orbite est, par exemple, du TaAs, du TaP, du NbAs, du NbP, du Na₃Bi, du Cd₃As₂, du WTe₂ ou du MoTe₂.

En outre, une irradiation du matériau peut être mise en oeuvre avec des ions, comme les ions He ou les ions Ar.

Selon un cinquième cas, le matériau de la couche spin-orbite est un dichalcogénure de métaux de transition et de préférence, un dichalcogénure de type ROCh₂. Un tel matériau présente effectivement un bon effet Rashba.

Dans une telle formule, 'R' est par exemple choisi parmi du La, du Ce, du Pr, du Nd, du Sr, du Sc, du Ga, de l'Al, ou de l'In tandis que 'Ch' est choisi parmi du S, du Se ou du Te.

En variante ou en complément, la couche d'interfaçage comporte une ou plusieurs couches métalliques non ferromagnétiques pour favoriser la conversion du courant de spin en courant de charge.

Par exemple, la couche d'interfaçage peut être réalisée en une couche d'Al, de Y, de Ru, de Mg, de Ta ou de Ti.

Selon encore une autre variante compatible avec les modes de réalisation précédents, la couche d'interfaçage comprend une barrière en un matériau isolant, notamment un oxyde.

Une telle barrière peut, par exemple être réalisée en MgO ou en Al₂O₃ et sert à améliorer le processus d'injection de spin, mais également les propriétés du signal à lire par l'unité de lecture.

Dans chacun des modes de réalisation précédents, le sous-ensemble d'interfaçage 20 est en contact avec une face du sous-ensemble de polarisation en spin 22.

En outre, le sous-ensemble d'interfaçage 20 est propre à assurer l'interconversion du courant polarisé en spin en courant de charge, en fonction de l'état de polarisation ferroélectrique du sous-ensemble ferroélectrique 18.

L'électrode supérieure 24 comporte une couche métallique 38 et trois contacts, à savoir le deuxième contact C2, le troisième contact C3 et le quatrième contact C4.

La couche métallique 38 est en contact avec le sous-ensemble de polarisation en spin 22.

Les trois contacts C2, C3 et C4 sont des contacts électriques de lecture de l'état de la polarisation du sous-ensemble ferroélectrique 18.

Selon l'exemple décrit, le deuxième contact C2 et le quatrième contact C4 s'étendent principalement le long de la même direction, à savoir la deuxième direction longitudinale Y. Les deux contacts C2 et C4 sont donc opposés l'un à l'autre.

Le troisième contact C3 s'étend principalement le long d'une direction perpendiculaire à la direction principale des contacts C2 et C4.

Le troisième contact C3 est connecté électriquement à la couche métallique 38.

De fait, le premier contact C1 est positionné sur la partie non superposée 32 et plus précisément sur la barre verticale du T de la partie non superposée 32.

Le premier contact C1 connecte électriquement le sous-ensemble d'interfaçage 20, et notamment la première partie 34 du sous-ensemble d'interfaçage 20.

De plus, le premier contact C1 est accessible par le dessus puisqu'il n'est pas recouvert par le sous-ensemble de polarisation en spin 22.

Le premier contact C1 est un contact électrique de lecture de l'état de la polarisation du sous-ensemble ferroélectrique 18.

Le fonctionnement de la mémoire 10 est maintenant décrit.

Lors de l'écriture, l'unité d'écriture vient charger la couche de contact 28 de l'électrode inférieure 16.

Par exemple, l'unité d'écriture est un transistor permettant de charger positivement ou négativement la couche de contact 28.

Lors de la lecture, dans une première méthode, l'unité de lecture applique un courant (ou une tension) entre le premier contact C1 et le troisième contact C3.

Du fait de l'agencement particulier de la figure 1, le courant injecté entre le premier contact C1 et le troisième contact C3 passe entièrement du sous-ensemble de polarisation en spin 22 vers le sous-ensemble d'interfaçage 20.

L'unité de lecture vient alors mesurer la tension entre le deuxième contact C2 et le quatrième C4, ou entre l'un contact parmi le deuxième contact C2 et le quatrième contact C4, et un potentiel électrique de référence.

Dans une seconde méthode, réciproque de la première, l'unité de lecture applique un courant (ou une tension) entre le deuxième contact C2 et le quatrième contact C4. L'unité de lecture vient alors mesurer la tension entre le premier contact C1 et le troisième contact C3, ou entre un contact parmi le contact C1 et le troisième contact C3, et un potentiel électrique de référence.

Dans ces deux méthodes le courant ne traverse donc pas le sous-ensemble ferroélectrique 18.

La tension mesurée dépend du courant injecté et de la polarisation électrique selon la direction d'empilement Z du sous-ensemble ferroélectrique 18, puisque le sous-ensemble ferroélectrique 18 contrôle électriquement et de manière non-volatile l'interconversion du courant de spin en courant de charge réalisée.

L'unité de lecture est donc capable de mesurer la polarisation électrique du sous-ensemble ferroélectrique 18 avec une sous-unité d'injection de courant et une sous-unité de mesure de la tension.

Cette mesure a la particularité de conserver l'état de polarisation du sous-ensemble ferroélectrique 18 et est donc non destructive.

La mémoire 10 est donc une mémoire à lecture non destructive.

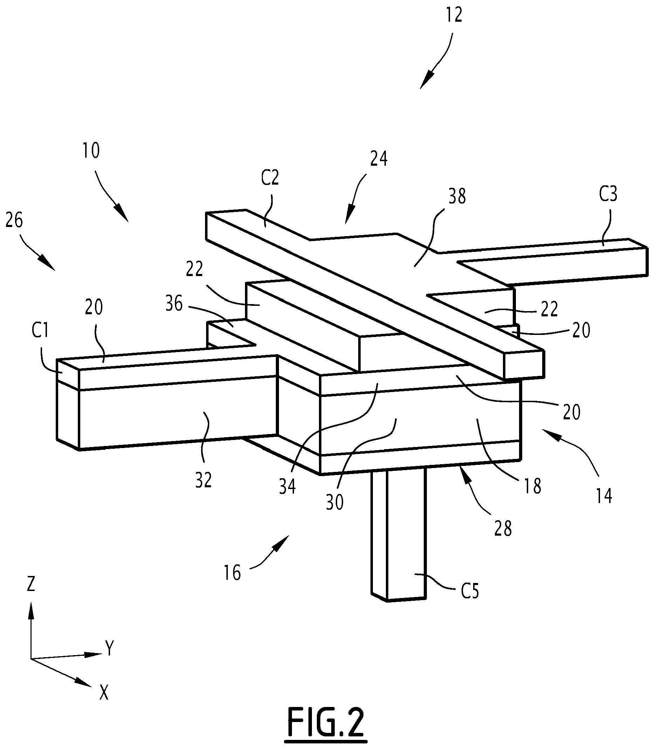

D'autres modes de réalisation de la mémoire 10 sont envisageables en référence aux figures 2, 3, et 4.

Dans ces figures, les éléments communs avec le mode de réalisation de la figure 1 ne sont pas répétés, seules les différences étant soulignées.

Dans le cas de la figure 2, un des contacts électriques s'étendant selon la direction perpendiculaire à la direction des premier et troisième contacts C1 et C3 est supprimée.

Ici, seul le deuxième contact C2 est conservé.

En fonctionnement, l'injection du courant de lecture entre les premier et troisième contacts C1 et C3 entraîne un mouvement de charges au travers du deuxième contact C2.

Au lieu de mesurer la tension comme dans le mode de réalisation de la figure 1, l'unité de lecture vient mesurer ce mouvement de charges, par exemple en mesurant le potentiel électrique du deuxième contact C2.

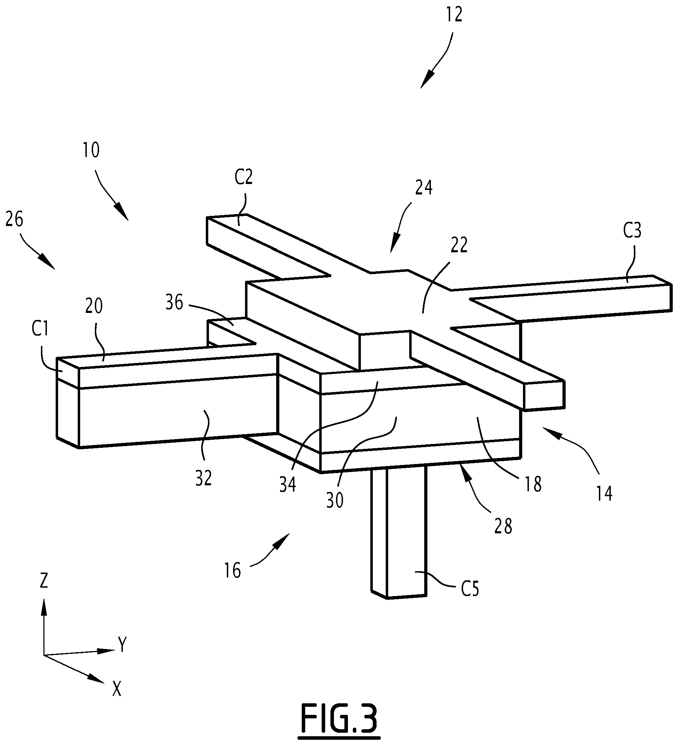

Pour la figure 3, les deuxième, troisième et quatrième contacts C2, C3 et C4 sont réalisés dans le sous-ensemble de polarisation en spin 22, de sorte que l'électrode supérieure 38 et le sous-ensemble de polarisation en spin 22 sont confondus.

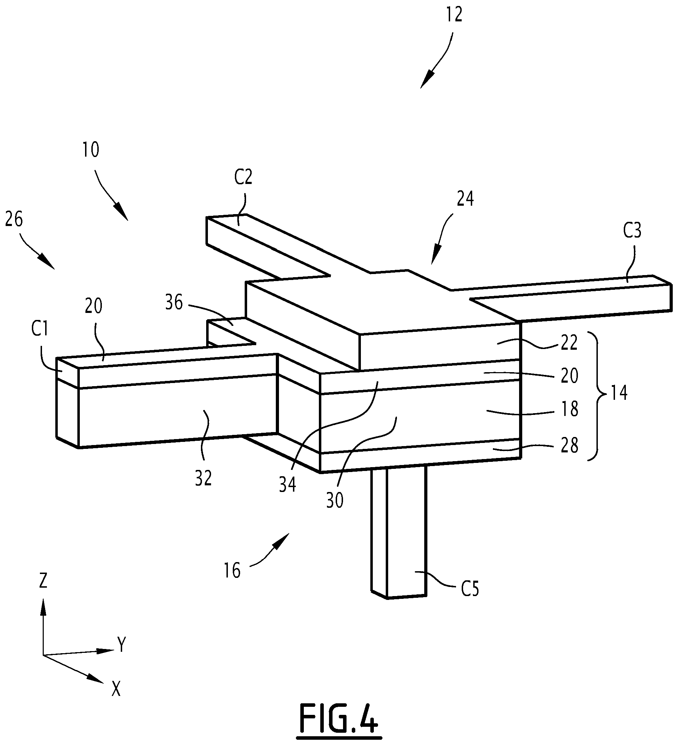

Un autre mode de réalisation de la mémoire est décrit en référence à la figure 4.

La mémoire 10 représentée sur la figure 4 correspond à la combinaison des mémoires 10 selon les figures 2 et 3 (contacts C2 et C3 réalisés dans le sous-ensemble de polarisation en spin 22).

Le dispositif électronique 12 qui vient d'être présenté pour une application à une mémoire 10 peut également être utilisé comme élément de base d'autres systèmes et en particulier un dispositif logique ou un dispositif neuromorphique. Dans le cas d'un dispositif neuromorphique, le sous-ensemble ferroélectrique 18 est conçu de manière à posséder des états stables de renversement partiel de la polarisation électrique apparente. La tension d'écriture et le temps pendant lequel cette tension est appliquée permettent d'atteindre ces états, qui correspondent à des tensions de lecture différentes.

Le dispositif électronique 12 peut également être utilisé comme élément de base de système logique. La tension de lecture d'un premier dispositif est alors connectée à un deuxième dispositif, de manière à servir de tension d'écriture pour le deuxième dispositif.

## Revendications

1. Dispositif électronique (12) comprenant un empilement de couches (14) empilées selon une direction d'empilement (Z), l'empilement de couches (14) comprenant :
- une première électrode (16), comprenant au moins un contact électrique (C5),
- un sous-ensemble ferroélectrique (18), le sous-ensemble ferroélectrique (18) étant en contact avec la première électrode (16) et présentant une polarisation ferroélectrique pouvant prendre plusieurs états,
- un sous-ensemble de polarisation en spin (22), le sous-ensemble de polarisation en spin (22) étant propre à polariser en spin un courant passant au travers du sous-ensemble de polarisation en spin (22), au moins une couche du sous-ensemble de polarisation en spin (22) étant en matériau ferromagnétique ou ferrimagnétique,
- un sous-ensemble d'interfaçage (20) disposé entre le sous-ensemble ferroélectrique (18) et le sous-ensemble de polarisation en spin (22), le sous-ensemble d'interfaçage (20) étant propre à assurer l'interconversion du courant polarisé en spin en courant de charge, en fonction de l'état de polarisation ferroélectrique du sous-ensemble ferroélectrique (18),
le sous-ensemble ferroélectrique (18) et le sous-ensemble d'interfaçage (20) présentant respectivement une partie superposée (30, 34) selon la direction d'empilement (Z) avec le sous-ensemble de polarisation en spin (22) et une partie non superposée (32, 36) avec le sous-ensemble de polarisation en spin (22), au moins un sous-ensemble parmi le sous-ensemble d'interfaçage (20) et le sous-ensemble ferroélectrique (18) comportant une couche conductrice apte à former une électrode intermédiaire (26), cette électrode intermédiaire (26) comprenant un contact (C1) électrique de lecture de l'état de polarisation du sous-ensemble ferroélectrique (18), et
- une deuxième électrode (24) comprenant au moins deux contacts (C2, C3, C4) électriques de lecture de l'état de la polarisation du sous-ensemble ferroélectrique (18), les contacts (C2, C3, C4) s'étendant chacun selon une direction principale respective, au moins deux directions principales étant non parallèles entre elles, la deuxième électrode (24) délimitant le sous-ensemble de polarisation en spin (22), le contact (C5) de la première électrode (16) permettant de modifier l'état de polarisation ferroélectrique du sous-ensemble ferroélectrique (18) par application d'une différence de potentiel entre ce contact (C5) et au moins l'un des contacts (C2, C3, C4) de la deuxième électrode (24) ou d'une différence de potentiel entre ce contact (C5) et le contact (C1) de l'électrode intermédiaire (26).

2. Dispositif selon la revendication 1 dans lequel le sous-ensemble d'interfaçage (20) comprend au moins :
- une couche en métal ou une barrière tunnel ou une couche à effet spin orbite, lorsque le sous-ensemble ferroélectrique (18) est tout ou partie conducteur ou semiconducteur, ou
- une couche en métal ou une barrière tunnel ou une couche à effet spin-orbite ou un gaz bidimensionnel d'électrons lorsque le sous-ensemble ferroélectrique (18) est isolant.

3. Dispositif selon la revendication 2, dans lequel le sous-ensemble ferroélectrique (18) comprend au moins une couche ferroélectrique semi-conductrice ou une couche ferroélectrique en matériau bidimensionnel conductrice ou semi-conductrice, ledit sous-ensemble d'interfaçage (20) étant confondu avec le sous-ensemble ferroélectrique (18) et comportant ladite au moins couche.

4. Dispositif selon l'une quelconque des revendications 1 à 3, dans lequel la deuxième électrode (24) est une couche positionnée sur le sous-ensemble de polarisation en spin (22).

5. Dispositif selon l'une quelconque des revendications 1 à 3, dans lequel la deuxième électrode (24) et le sous-ensemble de polarisation en spin (22) sont confondus.

6. Dispositif selon l'une quelconque des revendications 1 à 5, dans lequel la deuxième électrode (24) comporte au moins trois contacts (C2, C3, C4).

7. Dispositif selon la revendication 6, dans lequel deux contacts (C2, C4) de la deuxième électrode (24) s'étendent selon des directions principales parallèles, le troisième contact (C3) de la deuxième électrode (24) s'étendant selon une direction principale sensiblement perpendiculaire à la direction principale des deux autres contacts (C2, C4) de la deuxième électrode (24).

8. Dispositif selon l'une quelconque des revendications 1 à 7, dans lequel les directions principales de chaque contact (C1, C2, C3, C4) de l'électrode intermédiaire (26) et de la deuxième électrode (24) sont toutes perpendiculaires à la direction d'empilement (Z).

9. Dispositif selon l'une quelconque des revendications 1 à 8, dans lequel le contact (C5) de la première électrode est soit dans une direction perpendiculaire à la direction d'empilement (Z) soit dans une direction sensiblement parallèle à la direction d'empilement (Z).

10. Dispositif selon l'une quelconque des revendications 1 à 9, dans lequel le sous-ensemble d'interfaçage (20) comporte au moins un élément parmi un métal, un semi-métal de Weyl, un matériau bidimensionnel, un dichalcogénure de métaux de transition et un isolant topologique.

11. Dispositif selon l'une quelconque des revendications 1 à 10, dans lequel le sous-ensemble d'interfaçage (20) comprend une barrière en un matériau isolant, notamment un oxyde.

12. Dispositif selon l'une quelconque des revendications 1 à 11, dans lequel le sous-ensemble de polarisation en spin (22) comporte un alliage métallique ferromagnétique ou ferrimagnétique, un oxyde ferromagnétique ou ferrimagnétique, un semiconducteur magnétique, un élément ferromagnétique ou ferrimagnétique composite à plusieurs couches ferromagnétiques ou ferrimagnétiques et métalliques, un alliage d'Heusler ou un alliage ferromagnétique ou ferrimagnétique à base de terres rares.

13. Dispositif selon l'une quelconque des revendications 1 à 12, dans lequel le sous-empilement ferroélectrique (18) comprend un matériau ferroélectrique choisi parmi :
- un matériau de structure pérovskite de type ABO₃ avec A et B des cations,
- du (Hf₁₋ₓZrₓ)O₂, du (Hf₁₋ₓGaₓ)O₂ où x est compris entre 0 et 1, ou du HfO₂ dopé avec d'autres éléments tels que le Zr ou le Ga, ou leurs alliages,
- du poly(fluorure de vinylidène),
- un semiconducteur ferroélectrique, et
- un matériau ferroélectrique bidimensionnel.

14. Dispositif selon l'une quelconque des revendications 1 à 13, dans lequel les contacts (C1, C2, C3, C4) réalisent la lecture de l'état de polarisation du sous-ensemble de polarisation en spin (22) par application d'une tension de lecture entre deux contacts dits de lecture choisis parmi le contact (C1) de l'électrode intermédiaire (26) et les contacts (C2, C3, C4) de la deuxième électrode (24) et en mesurant la tension entre deux des autres contacts dits de lecture ou entre un desdits autres contacts dits de lecture et un potentiel de référence.

15. Système, notamment mémoire, dispositif logique ou dispositif neuromorphique, comportant un dispositif électronique (12) selon l'une quelconque des revendications 1 à 14.

## Patentansprüche

1. Elektronische Vorrichtung (12), umfassend einen Stapel von Schichten (14), die entlang einer Stapelrichtung (Z) gestapelt sind, der Stapel von Schichten (14) umfassend:
- eine erste Elektrode (16), umfassend mindestens einen elektrischen Kontakt (C5),
- eine ferroelektrische Unterbaugruppe (18), wobei die ferroelektrische Unterbaugruppe (18) in Kontakt mit der ersten Elektrode (16) ist und eine ferroelektrische Polarisation aufweist, die mehrere Zustände annehmen kann,
- eine Spinpolarisation-Unterbaugruppe (22), wobei die Spinpolarisation-Unterbaugruppe (22) geeignet ist, einen Strom, der durch die Spinpolarisation-Unterbaugruppe (22) fließt, zu spinpolarisieren, wobei mindestens eine Schicht der Spinpolarisation-Unterbaugruppe (22) aus ferromagnetischem oder ferrimagnetischem Material ist,
- eine Schnittflächen-Unterbaugruppe (20), die zwischen der ferroelektrischen Unterbaugruppe (18) und der Spinpolarisation-Unterbaugruppe (22) angeordnet ist, wobei die Schnittflächen-Unterbaugruppe (20) geeignet ist, um die Umkehrung des spinpolarisierten Stroms abhängig von dem ferroelektrischen Polarisationszustand der ferroelektrischen Unterbaugruppe (18) in einen Ladestrom zu gewährleisten,
wobei die ferroelektrische Unterbaugruppe (18) und die Schnittflächen-Unterbaugruppe (20) jeweils einen in Stapelrichtung (Z) mit der Spinpolarisation-Unterbaugruppe (22) überlagerten Teil (30, 34) und einen mit der Spinpolarisation-Unterbaugruppe (22) nicht überlagerten Teil (32, 36) aufweisen, wobei mindestens eine Unterbaugruppe der Schnittflächen-Unterbaugruppe (20) und der ferroelektrischen Unterbaugruppe (18) eine leitende Schicht aufweist, die eine Zwischenelektrode (26) bilden kann, diese Zwischenelektrode (26) umfassend einen elektrischen Kontakt (C1) zum Lesen des Polarisationszustands der ferroelektrischen Unterbaugruppe (18), und
- eine zweite Elektrode (24), umfassend mindestens zwei elektrische Kontakte (C2, C3, C4) zum Auslesen des Polarisationszustands der ferroelektrischen Unterbaugruppe (18), wobei sich die Kontakte (C2, C3, C4) jeweils entlang einer jeweiligen Hauptrichtung erstrecken, wobei mindestens zwei Hauptrichtungen nicht parallel zueinander sind, wobei die zweite Elektrode (24) die Spinpolarisation-Unterbaugruppe (22) begrenzt, wobei es der Kontakt (C5) der ersten Elektrode (16) ermöglicht, den ferroelektrischen Polarisationszustand der ferroelektrischen Unterbaugruppe (18) durch Anlegen einer Potentialdifferenz zwischen diesem Kontakt (C5) und mindestens einem der Kontakte (C2, C3, C4) der zweiten Elektrode (24) oder einer Potentialdifferenz zwischen diesem Kontakt (C5) und dem Kontakt (C1) der Zwischenelektrode (26) zu ändern.

2. Vorrichtung nach Anspruch 1, wobei die Schnittflächen-Unterbaugruppe (20) mindestens Folgendes umfasst:
- eine Metallschicht oder eine Tunnelbarriere oder eine Schicht mit Spin-Bahn-Effekt, wenn die ferroelektrische Unterbaugruppe (18) ganz oder teilweise leitend oder halbleitend ist, oder
- eine Metallschicht oder eine Tunnelbarriere oder eine Schicht mit Spin-Bahn-Effekt oder ein zweidimensionales Elektronengas, wenn die ferroelektrische Unterbaugruppe (18) isolierend ist.

3. Vorrichtung nach Anspruch 2, wobei die ferroelektrische Unterbaugruppe (18) mindestens eine halbleitende ferroelektrische Schicht oder eine ferroelektrische Schicht aus einem zweidimensionalen leitenden oder halbleitenden Material umfasst, wobei die Schnittflächen-Unterbaugruppe (20) mit der ferroelektrischen Unterbaugruppe (18) zusammenfällt und die mindestens eine Schicht umfasst.

4. Vorrichtung nach einem der Ansprüche 1 bis 3, wobei die zweite Elektrode (24) eine Schicht ist, die auf der Spinpolarisation-Unterbaugruppe (22) positioniert ist.

5. Vorrichtung nach einem der Ansprüche 1 bis 3, wobei die zweite Elektrode (24) und die Spinpolarisation-Unterbaugruppe (22) zusammenfallen.

6. Vorrichtung nach einem der Ansprüche 1 bis 5, wobei die zweite Elektrode (24) mindestens drei Kontakte (C2, C3, C4) umfasst.

7. Vorrichtung nach Anspruch 6, wobei sich zwei Kontakte (C2, C4) der zweiten Elektrode (24) in parallelen Hauptrichtungen erstrecken, sich der dritte Kontakt (C3) der zweiten Elektrode (24) in einer Hauptrichtung im Wesentlichen senkrecht zu der Hauptrichtung der zwei anderen Kontakte (C2, C4) der zweiten Elektrode (24) erstreckt.

8. Vorrichtung nach einem der Ansprüche 1 bis 7, wobei die Hauptrichtungen jedes Kontakts (C1, C2, C3, C4) der Zwischenelektrode (26) und der zweiten Elektrode (24) alle senkrecht zu der Stapelrichtung (Z) sind.

9. Vorrichtung nach einem der Ansprüche 1 bis 8, wobei der Kontakt (C5) der ersten Elektrode entweder in einer Richtung senkrecht zu der Stapelrichtung (Z) oder in einer Richtung im Wesentlichen parallel zu der Stapelrichtung (Z) ist.

10. Vorrichtung nach einem der Ansprüche 1 bis 9, wobei die Schnittlächen-Unterbaugruppe (20) mindestens ein Element, ausgewählt aus einem Metall, einem Weyl-Halbmetall, einem zweidimensionalen Material, einem Übergangsmetalldichalcogenid und einem topologischen Isolator umfasst.

11. Vorrichtung nach einem der Ansprüche 1 bis 10, wobei die Schnittflächen-Unterbaugruppe (20) eine Barriere aus einem isolierenden Material, insbesondere einem Oxid, umfasst.

12. Vorrichtung nach einem der Ansprüche 1 bis 11, wobei die Spinpolarisation-Unterbaugruppe (22) eine ferromagnetische oder ferrimagnetische Metalllegierung, ein ferromagnetisches oder ferrimagnetisches Oxid, einen magnetischen Halbleiter, ein ferromagnetisches oder ferrimagnetisches Verbundelement mit mehreren ferromagnetischen oder ferrimagnetischen und metallischen Schichten, eine Heusler-Legierung oder eine ferromagnetische oder ferrimagnetische Legierung auf Seltenerdbasis umfasst.

13. Vorrichtung nach einem der Ansprüche 1 bis 12, wobei der ferroelektrische Unterstapel (18) ein ferroelektrisches Material umfasst, das ausgewählt ist aus:
- einem Material mit Perowskit-Struktur vom Typ ABO₃, wobei A und B Kationen sind,
- (Hf₁₋ₓZrₓ)O₂, (Hf₁₋ₓGaₓ)O₂, wobei x zwischen 0 und 1 liegt, oder HfO₂, das mit anderen Elementen wie beispielsweise Zr oder Ga dotiert ist, oder deren Legierungen,
- Poly(vinylidenfluorid),
- einem ferroelektrischen Halbleiter, und
- einem zweidimensionalen ferroelektrischen Material.

14. Vorrichtung nach einem der Ansprüche 1 bis 13, wobei die Kontakte (C1, C2, C3, C4) das Auslesen des Polarisationszustands der Spinpolarisation-Unterbaugruppe (22) durch Anlegen einer Lesespannung zwischen zwei sogenannten Lesekontakten, die ausgewählt sind aus dem Kontakt (C1) der Zwischenelektrode (26) und den Kontakten (C2, C3, C4) der zweiten Elektrode (24), und durch Messen der Spannung zwischen zwei der anderen sogenannten Lesekontakte oder zwischen einem der anderen sogenannten Lesekontakte und einem Bezugspotenzial durchführen.

15. System, insbesondere Speicher, logische Vorrichtung oder neuromorphe Vorrichtung, umfassend eine elektronische Vorrichtung (12) nach einem der Ansprüche 1 bis 14.

## Claims

1. An electronic device (12) comprising a stack of layers (14) stacked along a direction of stacking (Z), the stack of layers (14) comprising:
- a first electrode (16), comprising at least one electrical contact (C5),
- one ferroelectric subassembly (18), the ferroelectric subassembly (18) being in contact with the first electrode (16) and having a ferroelectric polarization which can take a plurality of states,
- a spin-polarization subassembly (22), the spin-polarization subassembly (22) being adapted to spin-polarize a current flowing through the spin-polarization subassembly (22), at least one layer of the spin-polarization subassembly (22) being made of ferromagnetic or ferrimagnetic material,
- an interfacing subassembly (20) arranged between the ferroelectric subassembly (18) and the spin-polarization subassembly (22), the interfacing subassembly (20) being adapted to inter-convert the spin-polarized current into the charge current depending on the ferroelectric polarization state of the ferroelectric subassembly (18),
the ferroelectric subassembly (18) and the interfacing subassembly (20), respectively, having a part (30, 34) superimposed along the direction of stacking (Z), on the spin-polarization subassembly (22) and a part (32, 36) not superimposed on the spin-polarization subassembly (22), at least one of the interfacing subassembly (20) and the ferroelectric subassembly (18) including a conductive layer suitable for forming an intermediate electrode (26), said intermediate electrode (26) comprising an electrical contact (C1) for reading the state of polarization of the ferroelectric subassembly (18), and
- a second electrode (24) comprising at least two electrical contacts (C2, C3, C4) for reading the state of polarization of the ferroelectric subassembly (18), the contacts (C2, C3, C4) each extending along a respective main direction, at least two main directions being non-parallel to each other, the second electrode (24) delimiting the spin-polarization subassembly (22),
the contact (C5) of the first electrode (16) making it possible to change the ferroelectric polarization state of the ferroelectric subassembly (18) by application of a difference of potential between the contact (C5) and at least one of the contacts (C2, C3, C4) of the second electrode (24) or of a difference of potential between the contact (C5) and the contact (C1) of the intermediate electrode (26).

2. The device according to claim 1 wherein the interfacing subassembly (20) comprises at least:
- one metal layer or one tunnel barrier or one spin-orbit layer, when the ferroelectric subassembly (18) is all or in part conductive or semiconductive, or
- one metal layer or one tunnel barrier or one spin-orbit layer or one two-dimensional electron gas when the ferroelectric subassembly (18) is insulating.

3. The device according to claim 2, wherein the ferroelectric subassembly (18) comprises at least one semiconductive ferroelectric layer or a ferroelectric layer of conductive or semiconductive two-dimensional material, said interfacing subassembly (20) being merged with the ferroelectric subassembly (18) and including said at least one layer.

4. The device according to any one of claims 1 to 3, wherein the second electrode (24) is a layer positioned over the spin-polarization subassembly (22).

5. The device according to any one of claims 1 to 3, wherein the second electrode (24) and the spin-polarization subassembly (22) are merged.

6. The device according to any one of claims 1 to 5, wherein the second electrode (24) has at least three contacts (C2, C3, C4).

7. The device according to claim 6, wherein two contacts (C2, C4) of the second electrode (24) extend along parallel main directions, the third contact (C3) of the second electrode (24) extending along a main direction substantially perpendicular to the main direction of the other two contacts (C2, C4) of the second electrode (24).

8. The device according to any one of claims 1 to 7, wherein the main directions of each contact (C1, C2, C3, C4) of the intermediate electrode (26) and the second electrode (24) are all perpendicular to the direction of stacking (Z).

9. The device according to any one of claims 1 to 8, wherein the contact (C5) of the first electrode is either along a direction perpendicular to the direction of stacking (Z) or along a direction substantially parallel to the direction of stacking (Z).

10. The device according to any one of claims 1 to 9, wherein the interfacing subassembly (20) includes at least one element amongst a metal, a Weyl semi-metal, a two-dimensional material, a transition metal dichalcogenide and a topological insulator.

11. The device according to any one of claims 1 to 10, wherein the interfacing subassembly (20) comprises a barrier made of an insulating material, in particular an oxide.

12. The device according to any one of claims 1 to 11, wherein the spin-polarization subassembly (22) includes a ferromagnetic or ferrimagnetic metal alloy, a ferromagnetic or ferrimagnetic oxide, a magnetic semiconductor, a ferromagnetic or ferrimagnetic composite element with a plurality of ferromagnetic or ferrimagnetic and metallic layers, a Heusler alloy or a rare earth ferromagnetic or ferrimagnetic alloy.

13. The device according to any one of claims 1 to 12, wherein the-ferroelectric sub-stack (18) comprises a stack of a ferroelectric material chosen amongst:
- a material with a perovskite structure of the type ABO₃ with A and B cations,
- (Hf₁₋ₓZRₓ)O₂, (Hf₁₋ₓGAₓ)O₂ where x is comprised between 0 and 1, or HfO₂ doped with other elements such as Zr or Ga, or alloys thereof,
- poly(vinylidene fluoride),
- a ferroelectric semiconductor, and
- a two-dimensional ferroelectric material.

14. The device according to any one of claims 1 to 13, wherein the contacts (C1, C2, C3, C4) perform the reading of the polarization state of the spin-polarization subassembly (22) by application of a read voltage between two so-called read contacts chosen from the contact (C1) of the intermediate electrode (26) and the contacts (C2, C3, C4) of the second electrode (24) and by measuring the voltage between two of the other so-called read contacts or between one of said other so-called read contacts and a reference potential.

15. A system, in particular memory, logic device or neuromorphic device, including an electronic device (12) according to any one of claims 1 to 14.
